**Europäisches Patentamt**

**European Patent Office**

**Office européen des brevets**

(19)

(11) Numéro de publication: **0 004 238**

**A1**

(12) # DEMANDE DE BREVET EUROPEEN

(21) Numéro de dépôt: **79400142.0**

(22) Date de dépôt: **06.03.79**

(51) Int. Cl.²: **H 01 L 29/06**

(30) Priorité: **14.03.78 FR 7807280**

(43) Date de publication de la demande:
**19.09.79 Bulletin 79/19**

(84) Etats contractants désignés:
**BE DE GB NL**

(71) Demandeur: **"THOMSON-CSF"**
**173, boulevard Haussmann**
**F-75360 Paris Cedex 08 (FR)**

(72) Inventeur: **Tonnel, Eugène**
**"THOMSON-CSF" - SCPI 173, bld Haussmann**
**F-75360 Paris Cedex 08 (FR)**

(74) Mandataire: **Giraud, Pierre et al,**
**"THOMSON-CSF" - SCPI 173, bld Haussmann**
**F-75360 Paris Cedex 08 (FR)**

(54) **Circuit intégré et son procédé de fabrication.**

(57) Cette invention concerne les circuits intégrés sur un cristal semiconducteur et qui fonctionnent à des tensions de l'ordre de 40 volts.

Dans ce cas de hautes tensions, les champs électriques qui s'exercent entre deux couches du circuit intégré sont assez importants pour faire migrer les charges d'électrons qui se trouvent dans une couche (5), et inverser la conductivité du semiconducteur. L'invention prévoit de munir les points sensibles du circuit intégré d'un écran (16), porté à un potentiel déterminé, et qui entourne complètement chaque région sensible.

Applications aux circuits intégrés, notamment à ceux destinés aux installations téléphoniques.

Fig_4

1

# CIRCUIT INTEGRE ET SON PROCEDE DE FABRICATION

La présente invention concerne les circuits électroniques intégrés sur une pastille d'un matériau semiconducteur tel que le silicium, et porte plus particulièrement sur l'architecture de ces circuits, dont la stabilité, la densité d'intégration et la tenue en tension sont améliorées par la réalisation d'un écran électrostatique, cette architecture étant telle que, par une structure multicouche, elle permet de réaliser, simultanément à l'écran, des résistances et des connexions internes, ainsi qu'un meilleur positionnement relatif des diverses couches du circuit.

La nécessité de faire fonctionner les circuits intégrés sous des tensions relativement importantes, c'est-à-dire supérieures à 40 volts, leur confère les caractéristiques suivantes :

- les distances entre les divers composants actifs doivent être importantes pour permettre l'extension des zones de charge d'espace développées par les tensions élevées appliquées aux jonctions ;

- le silicium utilisé doit être de forte résistivité - à cause des tensions élevées et pour éviter que le type de surfaces ne soient inversées, les couches d'oxydes, d'isolation des connexions, doivent être épaisses pour réduire l'influence capacitive qu'elles excercent sur le silicium.

La résistivité du silicium ou l'épaisseur des oxydes isolants ne sont pas, comme les distances entre éléments actifs, une gêne à la densité d'intégration ; par contre, ces caractères rendent les circuits intégrés sensibles aux déplacements de charges électriques mobiles qui peuvent se manifester à la surface des couches ou dans le volume des diélectriques.

Ces charges mobiles commandent, par leur déplacement, l'ouverture de canaux dans lesquels la conductivité du semiconducteur est inversée, avec, dans certains cas, court-circuit entre deux zones, et, par voie de conséquence, un mauvais fonctionnement du dispositif.

Pour empêcher la formation de ces canaux parasites, l'invention prévoit de contrôler le déplacement des charges mobiles, par le contrôle du potentiel à l'interface entre couches isolantes et/ou semiconductrices en disposant un écran qui entoure complètement les régions critiques.

Plus précisément, il s'agit d'une structure de circuit intégré comportant, sur une face principale d'une plaquette semiconductrice, au moins une couche semiconductrice dans laquelle une région d'un type de conductivité donné est située entre deux régions d'un type de conductivité opposé à celui de la première région, cette première couche semiconductrice étant recouverte par une autre couche isolante, cette structure étant caractérisée en ce qu'un écran déposé sur la seconde couche isolante recouvre la totalité de la région de surface de la jonction entre deux régions connexes, écran assurant par application d'un potentiel donné, le contrôle de la migration, sous l'action du champ électrique créé par les différences de potentiel entre les différentes régions, des charges électriques à l'interface de l'une ou l'autre couches.

L'invention sera mieux comprise par la description suivante qui s'appuie sur les figures jointes parmi lesquelles :

    - la figure 1 illustre le déplacement des charges électriques, et la formation d'un canal parasite ;

    - la figure 2 représente un dispositif selon l'art connu, vu en coupe ;

    - la figure 3 représente le même dispositif, vu en plan ;

    - la figure 4 représente un dispositif muni des perfectionnements selon l'invention, vu en coupe ;

    - la figure 5 représente ce même dispositif, vu en plan ;

    - la figure 6 représente les différentes étapes de réalisation d'un circuit intégré, selon le procédé de l'invention.

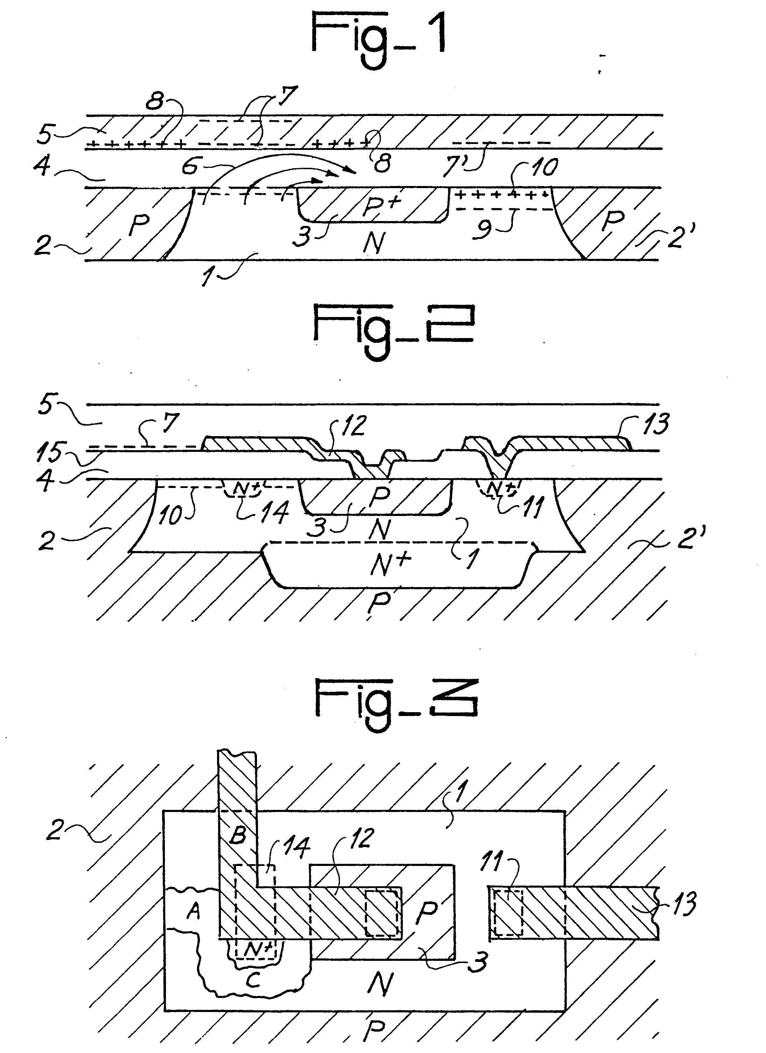

La figure 1 illustre les phénomènes qui, dans une jonction

$P^+N$ de diode prise à titre d'exemple, concourent à la formation d'un canal parasite. Cette diode schématise par exemple la jonction collecteur-base d'un transistor NPN ou PNP latéral.

Dans une couche 1 de silicium épitaxiée de type N sont diffusés des murs d'isolement 2 et 2', de type P et une région 3 du type $P^+$ qui, avec la région 1 de type N constitue la jonction. Une couche 4 isolante, par exemple de siliceSiO$_2$, recouvre l'ensemble ; elle est elle-même recouverte par une couche diélectrique 5 qui est par exemple une couche de silice déposée à basse température. Les prises de contacts ou autres métallisations ne sont pas représentées sur la figure.

Lorsque des tensions élevées sont appliquées, des champs électriques apparaissent entre différentes régions. On a représenté sur la partie gauche de la figure, un champ électrique entre la région 1 et la région 3 : ses lignes de forces 6, induites dans la couche isolante 4, déplacent les charges ioniques ou électroniques dans la couche diélectrique 5. Le déplacement en volume des ions peut être limité en dopant la couche isolante avec du phosphore par exemple. Le déplacement qui se produit à la surface, ou à l'interface de la couche isolante 4 et de la couche diélectrique 5 ne peut être évité. Ainsi, le champ électrique induit dans la silice 4 crée-t-il dans la couche 5 des zones 7 privilégiées en charge négatives et des zones 8 privilégiées en charges positives.

A ce premier phénomène s'ajoute une injection dans la silice 4 de charges électroniques issues du silicium sous-jacent, charges qui vont également se situer préférentiellement à l'interface des couches 4 et 5.

Les charges négatives qui apparaissent dans les deux cas au-dessus des régions peu dopées de type N de la couche épitaxiée 1 sont représentées sur la partie droite de la figure par la zone 7'. Ces charges négatives 7' sont souvent en quantité suffisante pour repousser les charges négatives 9 dans la couche 1 et inverser par effet capacitif la nature du silicium N dans lequel se crée un canal parasite 10 de type P, qui met en communication deux régions P, telle que 2-2' et 3, causant l'arrêt de fonctionnement du dispositif

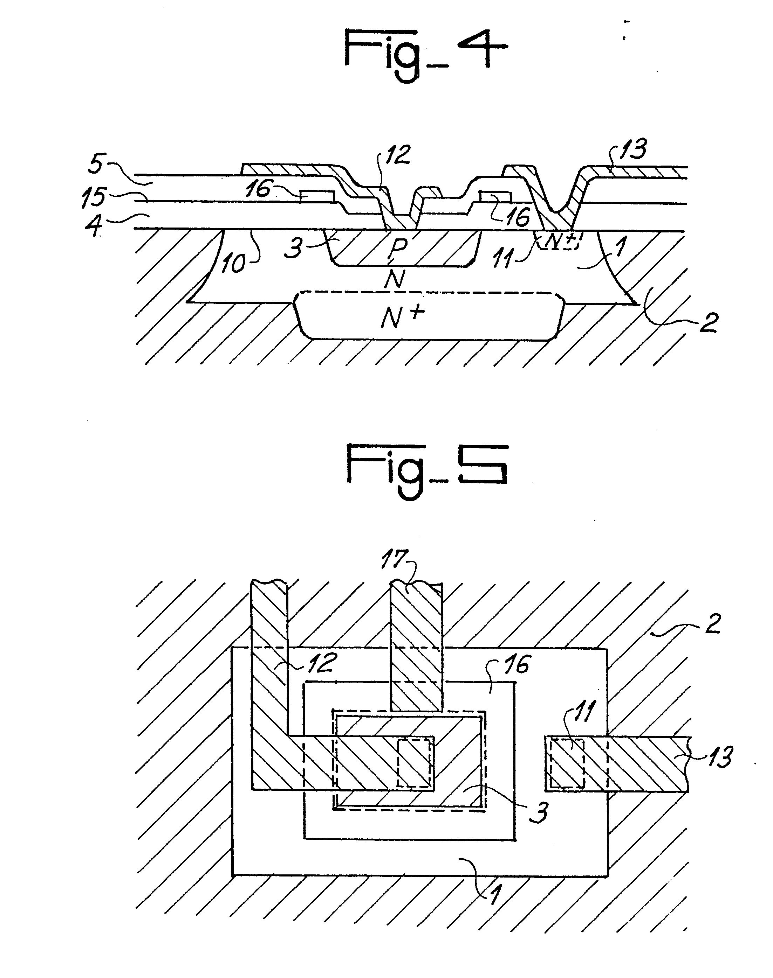

La figure 2 représente la coupe d'un dispositif selon l'art

connu : ce peut être la jonction collecteur base d'un transistor NPN ou PNP latéral. On y retrouve, comme sur la figure 1, une couche 1 de silicium épitaxiée de type N, délimitée par deux murs d'isolement 2 et 2', et une région 3 diffusée $P^+$ dans la région N. Une région $N^+$ 11 a été diffusée dans la région N, et les contacts sont pris, sur la diode $P^+N$ ainsi définie, par des métallisations 12 et 13. Les métallisations sont isolées du silicium sous-jacent par une couche 4 d'oxyde tel que la silice, et protégées de l'extérieur par une couche diélectrique 5, déposée à température suffisamment faible pour éviter la pénétration du métal dans le silicium. Les charges négatives 7 induisent le canal parasite 10, qui met en contact la diode 3 et l'isolement du mur 2.

Pour différer la formation de ce canal parasite 10, on augmente l'épaisseur des couches d'oxyde 4 et de diélectrique 5, et on dispose des barrières 14 très dopées $N^+$, localisées sous les connexions portées à un potentiel négatif par rapport à la région 1.

L'augmentation d'épaisseur de la couche 4 a pour effet de réduire l'influence capacitive des charges 7 de la région d'interface 15 avec la couche 5 : cette influence est parfaitement définie par la tension Vi qu'il faudra appliquer par exemple à la connexion 12 pour obtenir l'inversion des régions N. Les barrières 14 ont pour effet d'augmenter localement cette tension Vi de façon à permettre des fonctionnements à tensions plus élevées.

La figure 3 montrera mieux comment ces deux dispositions conduisent à des compromis techniques de plus en plus précaires, et à des produits dont la fiabilité reste limitée à tension élevée.

En effet lorsque les tensions appliquées à la connexion 12 par exemple dépassent la tension d'inversion Vi, la quantité des charges de la région 15 atteint un niveau suffisant pour ouvrir un canal P entre l'isolement 2 et la diode $P^+N$ 3. Ce canal représenté sur la figure 3 est constitué de trois sections distinctes placées en série, A, B et C, commandées par les charges de l'interface entre les couches 4 et 5 pour les sections A et C et par la connexion 12 pour la section B. On voit donc qu'il est nécessaire pour éviter le contournement C, que la région surdopée $N^+$ 14, entoure complétement la jonction de la diode $P^+N$ 3 ; cette solution utilisée classiquement dans les circuits intégrés à effet de champ canal N, exige de conserver une distance minimum entre la jonction 3 et le surdopage N$^+$ 14 pour éviter une limitation de la tenue en tension de la diode.

En définitive, les deux méthodes connues, basées sur l'augmentation d'épaisseur de la couche d'oxyde 4, typiquement de l'ordre de 2 micromètres pour des circuits fonctionnant à plus de 40 volts, et sur des barrières N$^+$ localisées sous les connexions critiques conduisent toutes deux à des compromis techniques de plus en plus délicats.

La solution proposée par l'invention consiste à contrôler le potentiel de l'interface 15 en disposant un écran qui entoure complètement les régions critiques.

Dans une réalisation simple l'écran peut être constitué par une partie de la couche métallique dans laquelle les connexions sont gravées. Dans ce cas, seules les régions simplement connexes peuvent être dotées d'un écran dont le potentiel est le même que celui de la connexion. Cette disposition appliquée généralement pour les émetteurs de transistors NPN ne peut être appliquée sur la jonction collecteur-base. En effet il faut interrompre dans ce cas l'écran de façon à laisser le passage des connexions émetteur et base. Ces discontinuités font perdre une grande partie de l'efficacité du contrôle de l'écran.

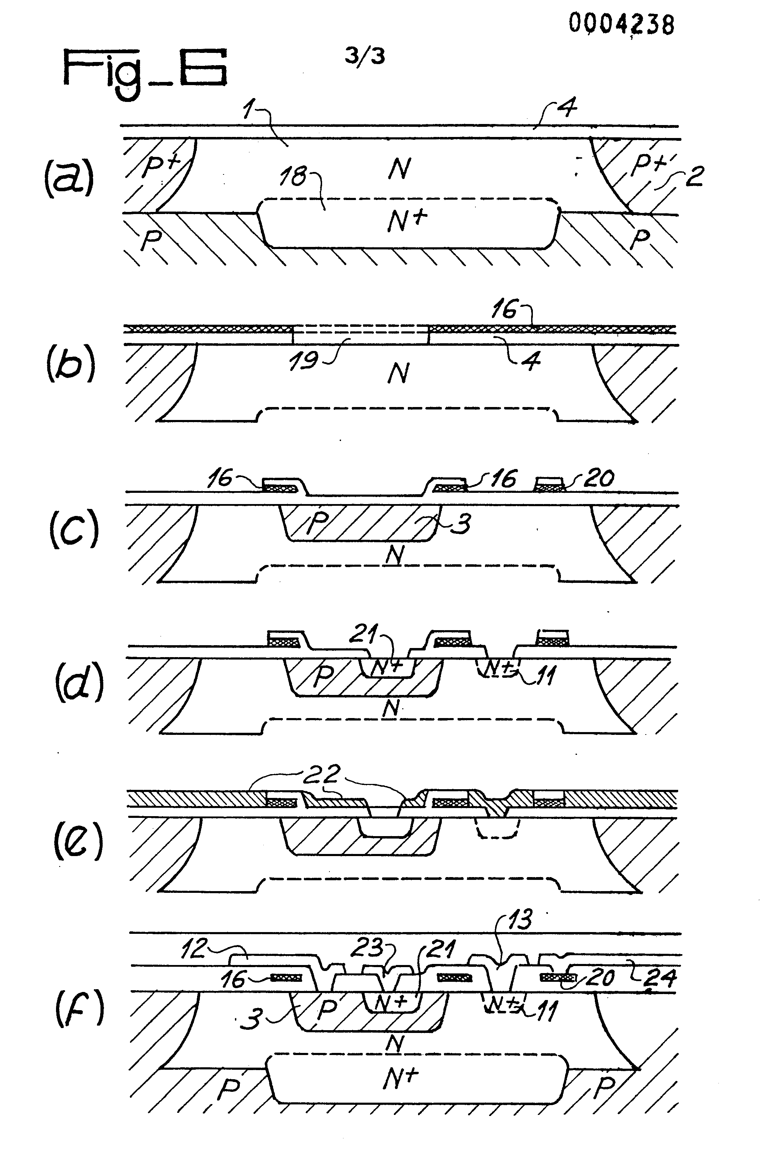

La figure 4 représente, vu en coupe, un dispositif proche de celui que représente la figure 2, mais qui a l'avantage d'être muni des perfectionnements de l'invention, et d'avoir par conséquent la structure correspondante.

Dans la solution proposée, l'écran 16 n'est plus dans le plan des connexions et permet de contrôler le potentiel de la totalité de la région 10, éliminant également l'influence exercée précédemment par la connexion 12. La réalisation de cet écran dans un plan différent de celui des connexions permet donc de contrôler la totalité de la surface à la périphérie de la jonction 3 tout en réduisant la surface de silicium occupée, les régions N$^+$ 14 n'étant plus nécessaires.

Cet écran 16 pourrait être constitué par une couche métallisée telle que l'aluminium : il est cependant nettement plus avantageux qu'il soit réalisé en silicium polycristallin.

D'une part, la diffusion de la région 3 peut se faire après le dépôt de la couche de silicium, ce qui n'est pas possible avec l'aluminium qui, au-delà d'une température de 450° C environ, pénètre dans le silicium. On peut ainsi, avec un seul masquage, graver le silicium puis la silice, et diffuser la région 3 qui est de la sorte parfaitement centrée à l'intérieur de l'écran 16 de silicium.

On pourrait obtenir un résultat analogue avec un métal réfractaire, mais on ne pourrait pas obtenir ultérieurement la couche de silice de protection par oxydation à haute température : cette couche d'oxyde thermique permet de déposer une seconde couche de silice pyrolitique, à plus basse température, couche qui donne avec la première couche 4 de silice une interface 15 de bonne qualité, sur laquelle les charges ne peuvent s'accumuler et réduire l'effet de l'écran.

D'autre part, puisqu'une couche de silicium polycristallin est déposée sur toute la surface de la plaquette, il est avantageux d'en utiliser des régions situées hors de l'écran pour en faire des résistances : la résistivité du silicium polycristallin est définie au cours de la diffusion P de la zone 3 et la couche de silicium polycristallin se prête ainsi à la réalisation de résistances de fortes valeurs mais cependant de petites dimensions, qui sont gravées au cours de la même opération que celle qui découpe le bord extérieur de l'écran.

Bien que les techniques de métallisation multicouches permettent d'obtenir deux niveaux de connexions isolées, l'interface 15 entre les deux diélectriques qui constituent les couches 4 et 5 est généralement de mauvaise qualité, car obtenu à relativement basse température. C'est pourquoi il est préférable de déposer la couche 5 à température élevée tout en obtenant une indexation naturelle de l'écran 16 avec la frontière des régions P.

Dans cette réalisation l'écran est gravé dans une couche de silicium polycristallin déposé sur la couche de silice thermique 4. Cette gravure doit être effectuée avant celle de la diode si on recherche l'indexation automatique du bord de l'écran et de la jonction de la diode. Le dopage du polycristal peut alors être effectué en même temps que celui de la base des transistors NPN par exemple.

L'utilisation de la couche de polycristal pour réaliser simultanément des résistances de fortes valeurs oblige à protéger ces régions lors de la diffusion de bore de façon à contrôler leur dopage ultérieur, par implantation par exemple.

Cependant le dopage obtenu au cours de la diffusion de la région 3 permet déjà de réaliser des résistances de 3 à 10 fois plus élevées que celles obtenues dans le monocristal. La disposition simultanée d'écrans et de résistances en polycristal permet donc d'améliorer notablement la tenue en tension tout en réduisant la dimension des circuits intégrés analogiques.

La figure 5 représente, vu en plan, le dispositif de la figure 4, et met en évidence la disposition de l'écran 16, qui entoure la région 3, et se trouve dans un plan intermédiaire entre celui de la région 3 et celui de la métallisation 12. Une connexion 17 permet de porter l'écran 16 à un potentiel fixé.

La figure 6 illustre les différentes étapes d'une réalisation, donnée à titre d'exemple sans caractère limitatif, mais qui permet de mieux comprendre l'invention et les avantages du procédé.

La figure 6a représente la plaquette de matériau semiconducteur avant les opérations particulières qui font l'objet de l'invention. La région 18 de type $N^+$ a été diffusée dans un substrat de type P, puis une couche épitaxiée 1 de type N a été déposée ; enfin les différents caissons ont été isolés par exemple par la diffusion des régions 2 de type $P^+$. Durant la diffusion des régions 2, une couche d'oxyde 4 se forme à la surface du silicium. Toutes ces opérations sont classiques, cependant on prête une attention particulière aux conditions de croissance de la couche d'oxyde 4 dont les propriétés d'épaisseur et de charges d'interface vont définir ultérieurement l'influence capacitive de l'écran.

La figure 6b représente les deux premières opérations de l'invention, dépôt de la couche de polycristal 16 et gravure 19 dans la couche 16 de l'ouverture dans laquelle la région 3 sera diffusée ; cette ouverture est obtenue par un procédé photogralithophique classique et servira de masque pour attaquer la couche de silice sous-jacente 4.

La figure 6c représente le dispositif après la diffusion de la région qui sera la base P d'un transistor NPN et la gravure de l'écran 16 et de résistance 20. La base de type P est diffusée dans l'ouverture 19 interne de l'écran 16. La gravure du bord externe de l'écran est ensuite effectuée en mêmetemps que celle des résistances, la couche de silicium polycristallin ayant été dopée lors de la diffusion de la région 3. Au cours de l'opération de recuit de la région 3, après diffusion, une couche de silice se forme à la surface de la couche de silicium polycristallin qui est ainsi protégé au cours de la gravure du bord externe de l'écran et des résistances. Dans le procédé décrit la largeur de l'écran 16 doit être suffisante pour tolérer les incertitudes qui résultent de l'indexation des deux gravures successives, les bords interne et externe étant gravés respectivement avant et après la diffusion de la base. Il est possible cependant, au prix d'opérations supplémentaires, d'éviter cette limitation par une technique de composition de masques.

La figure 6d représente les étapes classiques de la gravure et de la diffusion $N^+$ dans les régions 21 et 11 qui seront respectivement l'émetteur et le collecteur du transistor NPN pris pour exemple.

La figure 6e représente une étape propre à l'invention, durant laquelle on dépose une nouvelle couche d'oxyde de silicium 22 de façon à isoler les écrans et les résistances de la nappe de métallisation qui sera réalisée ultérieurement.

La figure 6f représente la structure achevée conformément à l'invention. Un masquage suivi d'une gravure dans la couche d'oxyde (4 + 22), aux endroits appropriés, a permis de prendre les contacts électriques au moyen des connexions métallisées 23 sur l'émetteur 21, 12 sur la base 3, 13 sur le collecteur 11, ainsi qu'une connexion 24 sur une résistance 20 représentée à titre d'exemple. Il est remarquable que la connexion 12 de la base du NPN passe par dessus l'écran 16 par rapport au plan du circuit intégré. Les connexions des régions dopées $N^+$ ne sont pas situées dans le plan de la coupe, mais peuvent de la même façon franchir la région d'écran 16. La connexion de l'écran lui- même peut-être directement reliée au collecteur du transistor.

Dans cette invention, un écran continu, réalisé grâce à une technique du type multicouches qui assure églement l'indexation automatique du bord de l'écran avec la région à contrôler, permet une augmentation de la tenue en tension des circuits intégrés.

En outre, l'utilisation d'une couche de silicium polycristallin dopée lors de la diffusion de la base des transistors NPN permet d'obtenir simultanément des résistances de fortes valeurs isolées diélectriquement et donc de réduire encore les dimensions du dispositif.

1

REVENDICATIONS

1. Circuit intégré comportant, sur une face principale d'une plaquette semiconductrice, au moins une couche semiconductrice dans laquelle une région (1) d'un type de conductivité donné est située entre deux régions (2 et 3) d'un type de conductivité opposé à celui de la première région, cette première couche semiconductrice étant recouverte par une autre couche isolante (4), cette structure étant caractérisée en ce qu'un écran (16), déposé sur la seconde couche isolante (4) recouvre la totalité de la région de surface de la jonction entre deux régions connexes, écran assurant par application d'un potentiel donné, le contrôle de la migration, sous l'action du champ électrique créé par les différences de potentiel entre les différentes régions, des charges électriques à l'interface de l'une et l'autre couches.

2. Circuit intégré selon la revendication 1, caractérisé en ce que l'écran est réalisé dans une couche de silicium polycristallin.

3. Circuit intégré selon la revendication 1, caractérisé en ce que les connexions métallisées entre éléments actifs du circuit sont isolées de l'écran et des résistances en silicium polycristallin par une couche isolante telle que la silice.

4. Procédé de fabrication d'une structure de circuit intégré selon les revendications 1 et 2, comportant une pluralité d'étapes de diffusion d'impuretés, caractérisé en ce que l'alignement, au cours de ces diffusions, du bord de l'écran et de la limite d'une région à contrôler est assuré par l'écran en silicium.

5. Procédé de fabrication d'une structure de circuit intégré selon les revendications 1 et 2, comportant une pluralité d'étapes de diffusion d'impuretés, caractérisé en ce que l'étape de diffusion de l'écran dans la couche de silicium polycristallin comporte la réalisation simultanée dans la même couche de résistances de fortes valeurs isolées.

0004238

# Fig_1

# Fig_2

# Fig_3

Fig_4

Fig_5

Fig_6

0004238

# RAPPORT DE RECHERCHE EUROPEENNE

| | DOCUMENTS CONSIDERES COMME PERTINENTS | | CLASSEMENT DE LA DEMANDE (Int. Cl.²) |
|---|---|---|---|
| Catégorie | Citation du document avec indication, en cas de besoin, des parties pertinentes | Revendication concernée | |
| X | US - A - 3 825 997 (SONY CORP.)<br>* Colonne 1, ligne 66 - colonne 5, ligne 44; figures 1-3 * | 1,2,4 | H.01 L 29/06 |
| X | FR - A - 1 562 742 (TELEFUNKEN)<br>* Résumé; figures 1-4 * | 1,2,4 | |
| X | US - A - 3 573 571 (GENERAL ELECTRIC COMP.)<br>* Colonne 2, lignes 6-20 *<br>& FR - A - 1 587 469 | 1 | |

DOMAINES TECHNIQUES RECHERCHES (Int. Cl.²)

H 01 L 29/06
27/06

CATEGORIE DES DOCUMENTS CITES

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

∝ Le présent rapport de recherche a été établi pour toutes les revendications

| Lieu de la recherche | Date d'achèvement de la recherche | Examinateur |
|---|---|---|
| La Haye | 07-05-1979 | CARDON |

OEB Form 1503.1  06.78